# EUROPEAN PATENT APPLICATION

(11) **EP 2 109 164 A1**
(43) Date of publication of application: **14.10.2009**
(21) Application number: 07859806.7
(22) Date of filing: 13.12.2007
(51) Int. Cl.: H01L 51/50, G09F 9/30, H01L 27/32, H05B 33/26

(54) **ORGANIC EL DISPLAY**

(30) Priority: 24.01.2007 JP 2007013221
(71) Applicant: Nippon Seiki Co., Ltd., Nagaoka-shi, Niigata 940-8580 (JP)
(72) Inventor: SAKAI, Kazunori, - (JP)
(74) Representative: Jackson, Richard Eric
(86) International application number: PCT/JP2007/073994
(87) International publication number: WO 2008/090688

(57) **Abstract**

An organic EL display is provided which, even in the event of increasing the number of light emitting pixels in a scanning line direction, can suppress an increase in applied current and voltage along with an increase in duty ratio, and can increase the definition of a display section. An organic EL display including an organic EL element in which a functional organic layer having at least a light emitting layer between signal electrodes 1 and scanning electrodes 2, which are disposed facing each other so as to intersect each other, is formed laminated on a substrate. The signal electrodes 1 have a plurality of pixel electrodes 1a disposed in a matrix form and a plurality of wiring electrodes 1b connected to differing pixel electrode 1a in each column of pixel electrodes 1a, and at least some of the wiring electrodes are formed stacked one above the other across an insulating layer, and a plurality of the scanning electrodes 2 are formed in such a way as to face the plurality of pixel electrodes 1a connected to each corresponding wiring electrode 1b.

## Description

### Technical Field

The present invention relates to an organic EL display using an organic electroluminescence (EL) element, and particularly, relates to a passive drive organic EL display.

### Background Art

As an organic EL element which is a self light emitting element formed of an organic material, for example, one is known wherein a positive electrode made of indium tin oxide (ITO) or the like, an organic layer having at least a light emitting layer, and a negative electrode made of aluminum (Al) or the like, are laminated in order, forming the organic EL element (refers to, for example, Patent Document 1).
Such an organic EL element is understood to emit light by holes being injected from the positive electrode, and electrons from the negative electrode, and the holes and electrons being recombined in the light emitting layer.

Also, in an organic EL display having an organic EL element provided on a transparent substrate, a passive drive method is known as its drive method. The passive drive organic EL display has a light emitting section configured by forming a signal electrode into a plurality of linear shapes on a transparent substrate, forming a scanning electrode into a plurality of linear shapes in such a way as to intersect the signal electrode, making a position in which the signal electrode intersects the scanning electrode a light emitting pixel, and disposing a plurality of the light emitting pixels. Such an organic EL display has a line-sequentially scanned image displayed in a display section. Such a passive drive organic EL display has an advantage of being easy to manufacture in comparison with an active drive method.
Patent Document 1: JP-A-59-194393
Patent Document 2: JP-A-2001-217081

### Disclosure of the Invention

### Problems that the Invention is to Solve

Also, due to an increase in amount, and a diversification, of information, in recent years, a further increase in scale and definition has been required of a display. However, in the event of increasing the light emitting pixels in the passive drive organic EL display, particularly, a light emitting drive duty ratio increases along with an increase of the scanning electrodes, reducing a voltage application time per line of scanning electrodes and, in order to make up for this, a current and voltage to be applied increase in proportion. For this reason, there is a problem in that it is difficult to increase the number of light emitting pixels on the scanning electrode side due to a limitation on drive IC or product specification requirements.

With respect to the heretofore described problem, as means for a reduction in voltage and current in the passive drive, Patent Document 2 discloses a method in which signal electrodes are formed in a pectinated electrode pattern in which rectangular pixel sections and thin leading line sections continue alternately, differing signal electrode pixel sections are combined nested inside one another at intersections with the scanning electrodes, and each of the intersections is configured in such a way that one scanning electrode and at least two signal electrodes (pixel sections) intersect. However, with such a method, there being a problem in that signal electrode wires (leading line sections) disposed between individual pixels increase, and a space between individual pixels increases, thus preventing an increase in definition of the display section, there is room for a further improvement.

The invention, focusing attention on the previously described problems, has an object of providing an organic EL display with which, even in the event of increasing the number of light emitting pixels in a scanning line direction, it is possible to suppress an increase in applied current and voltage along with an increase in duty ratio, and it is possible to increase the definition of a display section.

### Means for Solving the Problems

In order to solve the previously described problems, the invention is an organic EL display including an organic EL element in which a functional organic layer having at least a light emitting layer between signal electrodes and scanning electrodes, which are disposed facing each other in such a way as to intersect each other, is formed laminated on a substrate, **characterized in that** the signal electrodes have a plurality of pixel electrodes disposed in a matrix form and each of the plurality of wiring electrodes are connected to each of corresponding pixel electrodes in each column of pixel electrodes, and that at least some of the wiring electrodes are formed stacked one above the other across an insulating layer, and each of a plurality of the scanning electrodes are formed in such a way as to face the plurality of pixel electrodes connected to each corresponding wiring electrode in each column of pixel electrodes.

Also, the organic EL display is **characterized in that** scanning electrodes facing pixel electrodes connected to the same wiring electrode are classified as one unit, and a plurality of the scanning electrodes classified as differing units are driven and controlled with the same timing.

In order to solve the previously described problems, the invention is an organic EL display including an organic EL element in which a functional organic layer having at least a light emitting layer between signal electrodes and scanning electrodes, which are disposed facing each other in such a way as to intersect each other, is formed laminated on a substrate, **characterized in that** the signal electrodes have a plurality of pixel electrodes disposed in a matrix form and each of the plurality of wiring electrodes connect to each of corresponding pixel electrodes in each column of pixel electrodes, and that at least some of the wiring electrodes are formed stacked one above the other across an insulating layer, a plurality of the scanning electrodes are formed in such a way as to intersect the pixel electrode in each column of pixel electrodes, scanning electrodes intersecting the same pixel electrode are classified as one unit, and a plurality of the scanning electrodes classified as differing units are driven and controlled with the same timing.

Also, the organic EL display is **characterized in that** the wiring electrodes are wired between adjacent columns of pixel electrodes.

Also, the organic EL display is **characterized in that** the wiring electrodes are formed of a material with a lower electric resistance than that of the pixel electrodes.

Also, the organic EL display is **characterized in that** the wiring electrodes are wired toward one edge of the substrate.

In order to solve the previously described problems, the invention is an organic EL display including an organic EL element in which a functional organic layer having at least a light emitting layer between signal electrodes and scanning electrodes, which are disposed facing each other in such a way as to intersect each other, is formed laminated on a substrate, **characterized in that** the signal electrodes have a plurality of pixel electrodes disposed in a matrix form, and each of the plurality of wiring electrodes are connected to each of corresponding pixel electrodes in each column of pixel electrodes, and formed below the pixel electrodes across an insulating layer, and each of a plurality of the scanning electrodes are formed in such a way as to face the plurality of pixel electrodes connected to each corresponding wiring electrode in each column of pixel electrodes.

In order to solve the previously described problems, the invention is an organic EL display including an organic EL element in which a functional organic layer having at least a light emitting layer between signal electrodes and scanning electrodes, which are disposed facing each other in such a way as to intersect each other, is formed laminated on a substrate, **characterized in that** the signal electrodes have a plurality of pixel electrodes disposed in a matrix form, and each of the plurality of wiring electrodes connect to each of corresponding pixel electrodes in each column of pixel electrodes, and formed below the pixel electrodes across an insulating layer, and that a plurality of the scanning electrodes are formed in such a way as to intersect the pixel electrode in each column of pixel electrodes, scanning electrodes intersecting the same pixel electrode are classified as one unit, and a plurality of the scanning electrodes classified as differing units are driven and controlled with the same timing.

Also, the organic EL display is **characterized in that** a hole for connecting the pixel electrodes and wiring electrodes is formed in the insulating layer.

Also, the organic EL display is **characterized in that** the wiring electrodes are wired toward one edge of the substrate.

### Advantage of the Invention

The invention relating to the organic EL display using the organic EL element, and particularly, to a passive drive organic EL display, even in the event of increasing the number of light emitting pixels in the scanning line direction, it is possible to suppress an increase in applied current and voltage along with an increase in duty ratio, and it is possible to increase the definition of a display section.

### Brief Description of the Drawings

[Fig. 1] A schematic view showing an electrode structure of an organic EL display which is a first embodiment of the invention;
[Fig. 2] An enlarged view of a main portion of the organic EL display;
[Fig. 3] A sectional view of a main portion of the organic EL display;
[Fig. 4] An enlarged view of a main portion showing another example of the electrode structure of the organic EL display;
[Fig. 5] A schematic view showing an electrode structure of an organic EL display which is a second embodiment of the invention;
[Fig. 6] A sectional view of a main portion of the organic EL display;
[Fig. 7] A schematic view showing an electrode structure of an organic EL display which is a third embodiment of the invention;
[Fig. 8] A sectional view of a main portion of the organic EL display;
[Fig. 9] A schematic view showing an electrode structure of an organic EL display which is a fourth embodiment of the invention; and
[Fig. 10] A sectional view of a main portion of the organic EL display.

### Description of Reference Numerals and Signs

- 1, 11, 21, 31: Signal electrode
- 1a, 11a, 21a, 31a: Pixel electrode
- 1b, 11b, 21b, 31b: Wiring electrode
- 2, 12, 22, 32: Scanning electrode
- 2a, 12a, 22a, 32a: Rib
- 3, 13, 23, 33: Insulating layer
- 23a, 33a: Hole
- 4, 14, 24, 34: Insulating film
- 5, 15, 25, 35: Functional organic layer
- 6, 16, 26, 36: Glass substrate
- 7, 17, 27, 37: Signal electrode side drive circuit
- 8, 18, 28, 38: Scanning electrode side drive circuit

### Best Mode for Carrying Out the Invention

Hereafter, a description will be given, based on the accompanying drawings, of embodiments of the invention.

Firstly, a description will be given, based on the accompanying drawings, of an organic EL display which is a first embodiment of the invention. The organic EL display includes, as its basic component, an organic EL element in which a functional organic layer having at least a light emitting layer between signal electrodes and scanning electrodes, which are disposed facing each other in such a way as to intersect each other, is formed laminated on a transparent glass substrate.

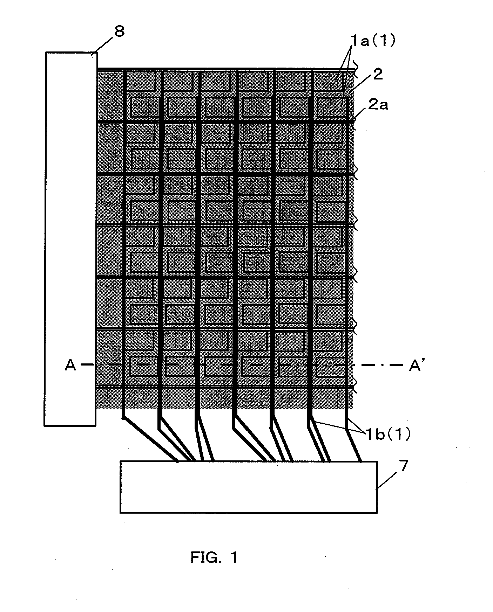

Fig. 1 shows one example of an electrode structure of the organic EL display which is the first embodiment of the invention. In the organic EL display, for example, signal electrodes 1 which, forming positive electrodes, have pixel electrodes 1a and wiring electrodes 1b, and scanning electrodes 2 which, forming negative electrodes, are formed in such a way as to intersect the signal electrodes 1, are formed on the glass substrate.

The organic EL display has a light emitting section configured by forming a light emitting pixel as one dot in each of portions in which the pixel electrodes 1a of the signal electrodes 1 face (intersect) the scanning electrodes 2, and disposing a plurality of the light emitting pixels. An insulating film (not shown) is formed in a portion other than the portions in which the signal electrodes 1 intersect the scanning electrodes 2, forming the light emitting pixels. By this means, it is possible to prevent a short circuit of the positive electrodes and negative electrodes.

The pixel electrodes 1a are configured by forming a transparent conductive material such as, for example, indium tin oxide (ITO) into a layer on the glass substrate by means of a method such as a sputtering method, and patterning it into a predetermined shape by means of, for example, a photolithographic method. In this embodiment, a plurality of the pixel electrodes 1a are disposed in a matrix form on the glass substrate formed in an approximately rectangular shape.

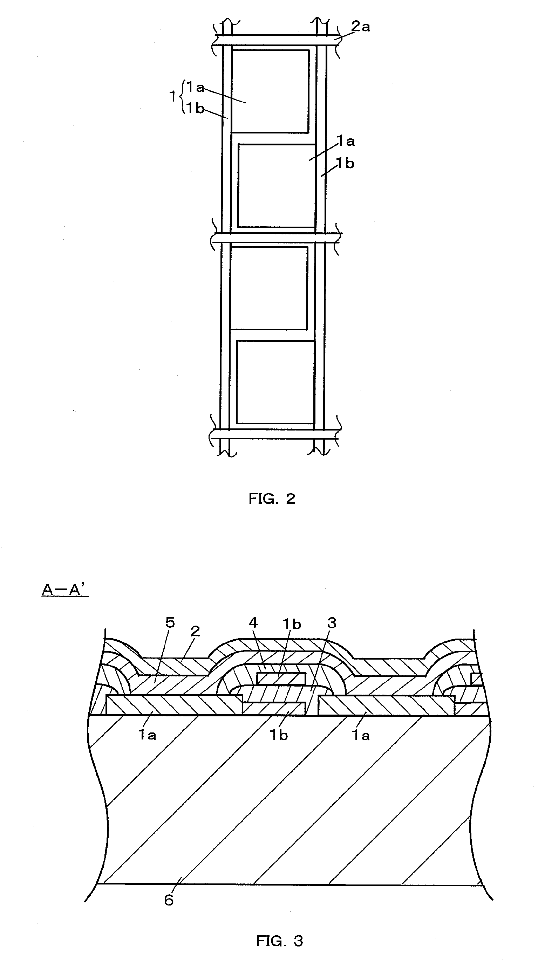

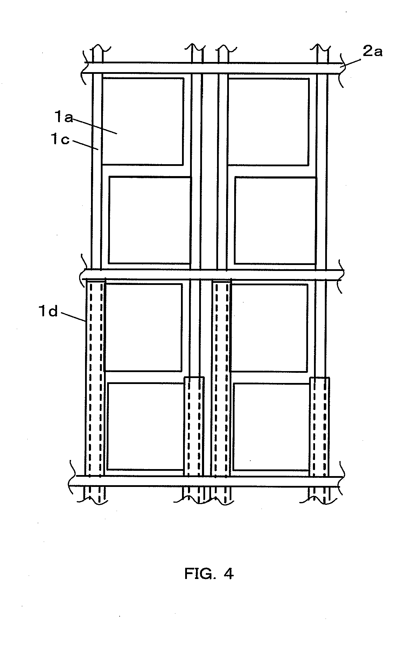

The wiring electrodes 1b are configured by forming a material such as chromium (Cr), which has a lower electric resistance than the component material of the pixel electrodes 1a, into a layer on the glass substrate by means of a method such as a sputtering method, and patterning it into a predetermined shape by means of, for example, a photolithographic method. Each of the wiring electrodes 1b is formed wired between adjacent columns of pixel electrodes 1a, and connected to alternate pixel electrodes 1a in each column of pixel electrodes 1a, as shown in the enlarged view of a main portion in Fig. 2 (illustrating only one column of pixel electrodes 1a). That is, in this embodiment, each of two wiring electrodes 1b for each column of pixel electrodes 1a is connected to differing pixel electrodes 1a. Also, as shown in the sectional view of a main portion in Fig. 3, the wiring electrodes 1b are disposed stacked one above the other across an insulating layer 3 made of an insulating resin material, forming a three-dimensional wiring structure. In Fig. 3, 4 is the previously described insulating film for short circuit prevention, 5 is a functional organic layer, and 6 is the glass substrate. Also, the wiring electrodes 1b are each wired toward one edge of the glass substrate, and connected to a signal electrode side drive circuit 7. The signal electrode side drive circuit 7 is one which supplies electric power to each pixel electrode 1a via the wiring electrodes 1b in order to display a predetermined image in accordance with a sequential scanning of the scanning electrodes 2 by a scanning electrode side drive circuit 8, to be described hereafter.

The scanning electrodes 2 are configured by, as well as forming a conductive material such as aluminum (Al) into a layer by means of a vapor deposition method or the like, separating and forming it into a plurality of rows of linear shapes by means of ribs 2a configured by forming an insulating resin material into linear shapes. Each of the scanning electrodes 2, intersecting each column of pixel electrodes 1a, is formed in such a way as to face two pixel electrodes 1a connected to each differing wiring electrode 1b in each column of pixel electrodes 1a. Also, the scanning electrodes 2 are each connected to the scanning electrode side drive circuit 8. The scanning electrode side drive circuit 8 is one which scans the scanning electrodes 2 in order using a predetermined duty ratio.

Such an organic EL display is configured so that two pixel electrodes 1a alternately connected to differing wiring electrodes 1b are disposed in such a way as to face each line of scanning electrodes 2 to be duty driven. That is, it is possible to, when scanning one line of scanning electrodes 2, individually light and control two dots in a vertical direction (a direction perpendicular to the scanning electrodes 2) of a display section by means of the signal electrode side drive circuit 7 side, and even in the event of increasing the number of dots in the vertical direction, it is possible to suppress a decrease in luminance lifetime, an increase in voltage, or an increase in consumption current and consumption power. Furthermore, with the organic EL display of this embodiment, it being possible to reduce a dimension between dots by three-dimensionally wiring the wiring electrodes 1b, it is possible to realize an increase in definition of the display section in spite of an increase of the wiring electrodes 1b.

In this embodiment, a configuration is such that the pixel electrodes 1a in each column are alternately connected by two wiring electrodes 1b, but it is also acceptable that the invention is of a configuration such that three or more wiring electrodes are connected to each corresponding pixel electrode for each column of pixel electrodes. That is, it is also acceptable to adopt a configuration such that three or more pixel electrodes connected to each differing wiring electrode are disposed facing one line of scanning electrodes. With such a configuration, by adopting the three-dimensional wiring structure wherein the wiring electrodes disposed between adjacent pixel electrodes are formed stacked one above the other across the insulating layer, it is possible to realize the increase in definition of the display section in spite of the increase of the wiring electrodes.

Fig. 4 shows one example of an electrode structure in a case in which four wiring electrodes are connected to one column of pixel electrodes 1a. In this case, the wiring electrodes include first wiring electrodes 1c and second wiring electrodes 1d formed stacked above the first wiring electrodes 1c across an insulating layer (not shown), and two first and two second wiring electrodes 1c and 1d are connected to one column of pixel electrodes 1a. A component material, and a forming method, of the first and second wiring electrodes are the same as the previously described ones. With such a configuration, it is possible to classify the scanning electrodes into an upper unit, which intersects the pixel electrodes 1a connected to the first wiring electrodes 1c, and a lower unit, which intersects the pixel electrodes 1a connected to the second wiring electrodes 1d, and it is possible to apply a so-called dual scan method which drives and controls a plurality of scanning electrodes classified as differing units with the same timing. With such a configuration, by adopting the three-dimensional wiring structure wherein at least some of the wiring electrodes disposed between adjacent columns of pixel electrodes are formed stacked one above the other across the insulating layer, it is possible to suppress an increase in distance between the pixel electrodes, and it is possible to realize the increase in definition of the display section in spite of the increase of the wiring electrodes.

Next, a description will be given, as a second embodiment of the invention, of an organic EL display to which is applied the so-called dual scan method which drives and controls the plurality of scanning electrodes with the same timing. The organic EL display includes, as its basic component, an organic EL element in which a functional organic layer, having at least a light emitting layer between the signal electrodes and scanning electrodes disposed facing each other in such a way as to intersect each other, is formed laminated on a transparent glass substrate.

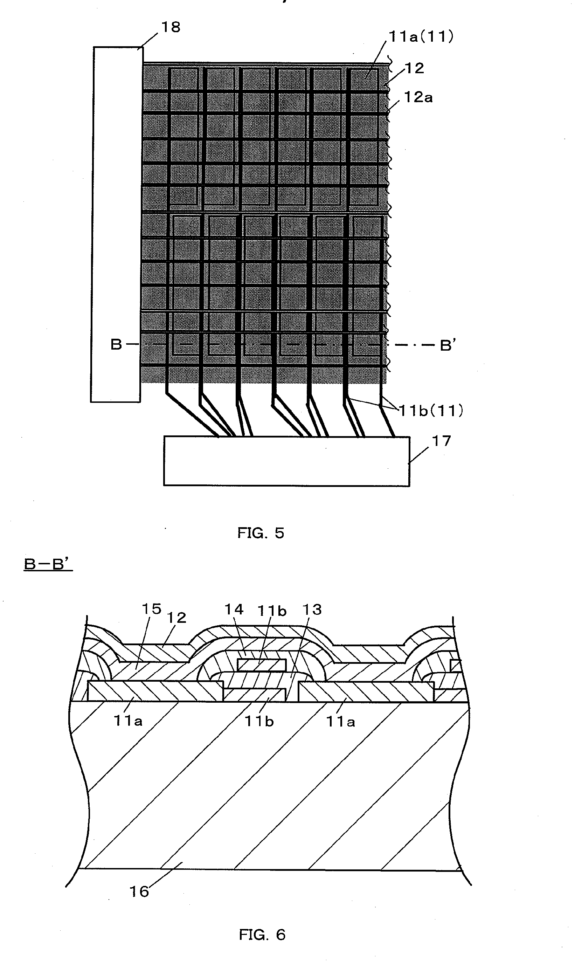

Fig. 5 shows one example of an electrode structure of the organic EL display which is the second embodiment of the invention. In the organic EL display, for example, signal electrodes 11 which, forming positive electrodes, have pixel electrodes 11a and wiring electrodes 11b, and scanning electrodes 12 which, forming negative electrodes, are formed in such a way as to intersect the signal electrodes 11, are formed on the glass substrate.

The organic EL display has a light emitting section configured by forming a light emitting pixel as one dot in each of portions in which the pixel electrodes 11a of the signal electrodes 11 face the scanning electrodes 12, and disposing a plurality of the light emitting pixels. An insulating film is formed in a portion other than the portions in which the signal electrodes 11 intersect the scanning electrodes 12, forming the light emitting pixels. By this means, it is possible to prevent a short circuit of the positive electrodes and negative electrodes.

The pixel electrodes 11a are configured by forming a transparent conductive material such as, for example, indium tin oxide (ITO) into a layer on the glass substrate by means of a method such as a sputtering method, and patterning it into a predetermined shape by means of, for example, a photolithographic method. In this embodiment, the pixel electrodes 11a are formed into linear shapes, and two pixel electrodes 11a configure one column.

The wiring electrodes 11b are configured by forming a material such as chromium (Cr), which has a lower electric resistance than the component material of the pixel electrodes 11a, into a layer on the glass substrate by means of a method such as a sputtering method, and patterning it into a predetermined shape by means of, for example, a photolithographic method. The wiring electrodes 11b are wired in such a way as to be connected to the individual pixel electrodes 11a. Also, as shown in the sectional view of a main portion in Fig. 6, the wiring electrodes 11b are disposed stacked one above the other across an insulating layer 13 made of an insulating resin material, forming a three-dimensional wiring structure. In Fig. 6, 14 is the previously described insulating film for short circuit prevention, 15 a functional organic layer, and 16 is the glass substrate. Also, the wiring electrodes 11b are each connected to a signal electrode side drive circuit 17. The signal electrode side drive circuit 17 is one which supplies electric power to each pixel
11electrode 11a via the wiring electrodes 11b in order to display a predetermined image in accordance with a sequential scanning of the scanning electrodes 12 by a scanning electrode side drive circuit 18, to be described hereafter.

The scanning electrodes 12 are configured by, as well as forming a conductive material such as aluminum (Al) into a layer by means of a vapor deposition method or the like, separating and forming it into a plurality of rows of linear shapes by means of ribs 12a configured by forming an insulating resin material into linear shapes. The scanning electrodes 12 are formed in such a way that a plurality thereof intersect one pixel electrode 11a. Also, the scanning electrodes 12, of which those intersecting the same pixel electrode11a are classified as one unit, are each connected to the scanning electrode side drive circuit 18. The scanning electrode side drive circuit 18 is one which scans a plurality of scanning electrodes 12 classified as differing units using a predetermined duty ratio, in order, with the same timing.

Such an organic EL display is configured so that two pixel electrodes 11a connected to each differing wiring electrode 11b are disposed in such a way as to face two units of scanning electrodes 12 to be duty driven with the same timing. That is, it is possible to, when scanning two lines of scanning electrodes 12 at the same time, individually light and control two dots in a vertical direction (a direction perpendicular to the scanning electrodes 12) of a display section by means of the signal electrode side drive circuit 17 side, and even in the event of increasing the number of dots in the vertical direction, it is possible to suppress a decrease in luminance lifetime, an increase in voltage, or an increase in consumption current and consumption power. Furthermore, with the organic EL display of this embodiment, it being possible to reduce a dimension between dots by three-dimensionally wiring at least some of the wiring electrodes 11b, it is possible to realize an increase in definition of the display section in spite of an increase of the wiring electrodes 11b.

In this embodiment, a configuration is one compatible with the dual scan method which drives and controls two lines of scanning electrodes 12 with the same timing but, in the invention, it is also acceptable to adopt one compatible with a configuration (a triple scan method) which classifies the scanning electrodes into three or more units, and drives and controls three or more lines of scanning electrodes with the same timing. With such a configuration, by adopting the three-dimensional wiring structure wherein the wiring electrodes disposed between adjacent pixel electrodes are formed stacked one above the other across the insulating layer, it is possible to realize the increase in definition of the display section in spite of the increase of the wiring electrodes.

Next, a description will be given, based on the accompanying drawings, of an organic EL display which is a third embodiment of the invention. The organic EL display includes, as its basic component, an organic EL element in which a functional organic layer having at least a light emitting layer between signal electrodes and scanning electrodes, which are disposed facing each other in such a way as to intersect each other, is formed laminated on a transparent glass substrate. In the organic EL display of this embodiment, a top emission type is applied which draws a display light from the rear side of (a direction opposite to) the glass substrate.

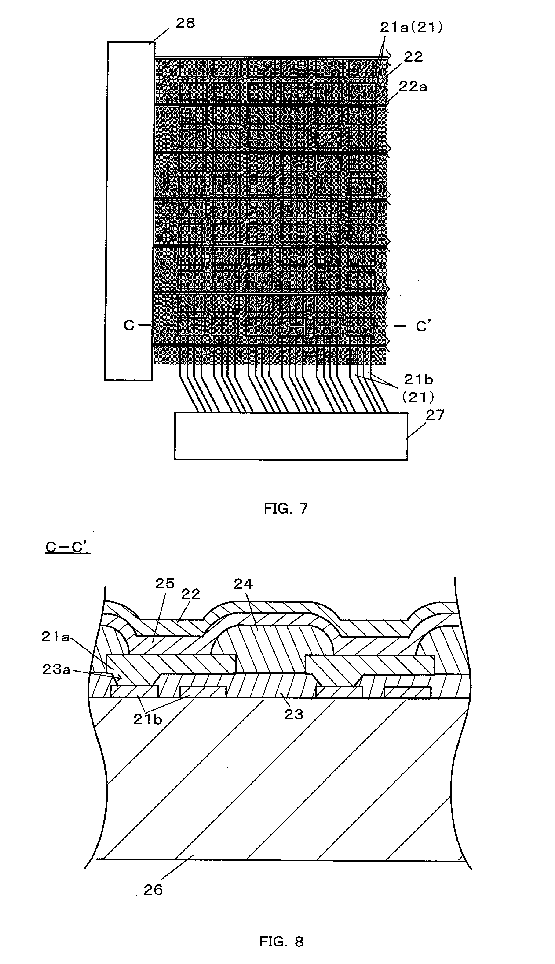

Fig. 7 shows one example of an electrode structure of the organic EL display which is the third embodiment of the invention. In the organic EL display, for example, signal electrodes 21 which, forming positive electrodes, have pixel electrodes 21a and wiring electrodes 21b, and scanning electrodes 22 which, forming negative electrodes, are formed in such a way as to intersect the signal electrodes 21, are formed on the glass substrate.

The organic EL display has a light emitting section configured by forming a light emitting pixel as one dot in each of portions in which the pixel electrodes 21a of the signal electrodes 21 face (intersect) the scanning electrodes 22, and disposing a plurality of the light emitting pixels. An insulating film (not shown) is formed in a portion other than the portions in which the signal electrodes 21 intersect the scanning electrodes 22, forming the light emitting pixels. By this means, it is possible to prevent a short circuit of the positive electrodes and negative electrodes.

The pixel electrodes 21a are configured by forming a conductive material such as, for example, aluminum (Al) into a layer on the glass substrate by means of a method such as a sputtering method, and patterning it into a predetermined shape by means of, for example, a photolithographic method. In this embodiment, a plurality of the pixel electrodes 21a are disposed in a matrix form on the glass substrate formed in an approximately rectangular shape.

The wiring electrodes 21b are configured by forming a material such as aluminum (Al), which has a low electric resistance, into a layer on the glass substrate by means of a method such as a sputtering method, and patterning it into a predetermined shape by means of, for example, a photolithographic method. Each of the wiring electrodes 21b is formed wired below the pixel electrodes 21a across an insulating layer, and connected to alternate pixel electrodes 21a in each column of pixel electrodes 21a. That is, in this embodiment, two wiring electrodes 21b for each column of pixel electrodes 21a are connected to differing pixel electrodes 21a. Also, as shown in the sectional view of a main portion in Fig. 8, each of the wiring electrodes 21b is connected to each pixel electrode 21a through a hole 23a formed in the insulating layer 23. In Fig. 8, 24 is the previously described insulating film for short circuit prevention, 25 is a functional organic layer, and 26 is the glass substrate. Also, the wiring electrodes 21b are wired toward one edge of the glass substrate, and connected to a signal electrode side drive circuit 27. The signal electrode side drive circuit 27 is one which supplies electric power to each pixel electrode 21a via the wiring electrodes 21b in order to display a predetermined image in accordance with a sequential scanning of the scanning electrodes 22 by a scanning electrode side drive circuit 28, to be described hereafter.

The scanning electrodes 22 are configured by, as well as forming a conductive material such as aluminum (Al) into a layer by means of a vapor deposition method or the like, separating and forming it into a plurality of rows of linear shapes by means of ribs 22a configured by forming an insulating resin material into linear shapes. In this embodiment, in order to apply the top emission type, the scanning electrodes 22 are formed as transparent electrodes, which can transmit light emitted from the functional organic layer, by means of a film thinning or the like. Each of the scanning electrodes 22, intersecting each column of pixel electrodes 21a, is formed in such a way as to face two pixel electrodes 21a connected to each differing wiring electrode 21b in each column of pixel electrodes 21a. Also, the scanning electrodes 22 are each connected to the scanning electrode side drive circuit 28. The scanning electrode side drive circuit 28 is one which scans the scanning electrodes 22 in order using a predetermined duty ratio.

Such an organic EL display is configured so that two pixel electrodes 21a alternately connected to differing wiring electrodes 21b are disposed in such a way as to face each line of scanning electrodes 22 to be duty driven. That is, it is possible to, when scanning one line of scanning electrodes 22, individually light and control two dots in a vertical direction (a direction perpendicular to the scanning electrodes 22) of a display section by means of the signal electrode side drive circuit 27 side, and even in the event of increasing the number of dots in the vertical direction, it is possible to suppress a decrease in luminance lifetime, an increase in voltage, or an increase in consumption current and consumption power. Furthermore, with the organic EL display of this embodiment, it being possible to reduce a dimension between dots by wiring the wiring electrodes 21b below the pixel electrodes 21a across the insulating layer 23, it is possible to realize an increase in definition of the display section in spite of an increase of the wiring electrodes 21b.

In this embodiment, a configuration is such that the pixel electrodes 21a in each column are alternately connected by two wiring electrodes 21b, but it is also acceptable that the invention is of a configuration such that three or more wiring electrodes for each column of pixel electrodes are connected to each differing pixel electrode. That is, it is also acceptable to adopt a configuration such that three or more pixel electrodes connected to each differing wiring electrode are disposed facing one line of scanning electrodes. With such a configuration, by disposing the wiring electrodes below the pixel electrodes across the insulating layer, it is possible to realize the increase in definition of the display section in spite of the increase of the wiring electrodes.

Next, a description will be given, based on the accompanying drawings, of an organic EL display to which a so-called dual scan method which drives and controls a plurality of scanning electrodes with the same timing is applied as a fourth embodiment of the invention. The organic EL display includes, as its basic component, an organic EL element in which a functional organic layer having at least a light emitting layer between signal electrodes and scanning electrodes, which are disposed facing each other in such a way as to intersect each other, is formed laminated on a transparent glass substrate. In the organic EL display of this embodiment, a top emission type is applied which draws a display light from the rear side of (a direction opposite to) the glass substrate.

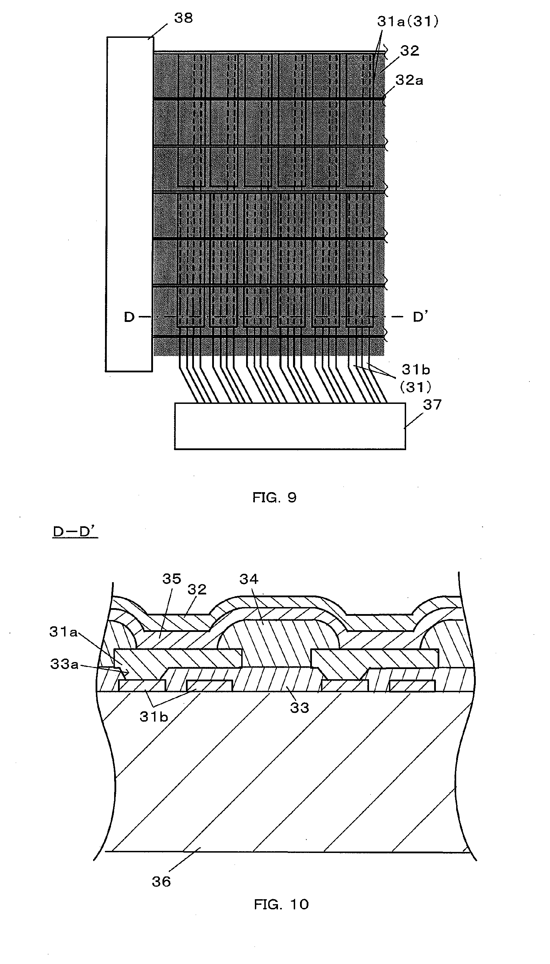

Fig. 9 shows one example of an electrode structure of the organic EL display which is the fourth embodiment of the invention. In the organic EL display, for example, signal electrodes 31 which, forming positive electrodes, have pixel electrodes 31a and wiring electrodes 31b, and scanning electrodes 32 which, forming negative electrodes, are formed in such a way as to intersect the signal electrodes 31, are formed on the glass substrate.

The organic EL display has a light emitting section configured by forming a light emitting pixel as one dot in each of portions in which the pixel electrodes 31a of the signal electrodes 31 face the scanning electrodes 32, and disposing a plurality of the light emitting pixels. An insulating film is formed in a portion other than the portions in which the signal electrodes 31 intersect the scanning electrodes 32, forming the light emitting pixels. By this means, it is possible to prevent a short circuit at the intersections of the positive electrodes and negative electrodes.

The pixel electrodes 31a are configured by forming a conductive material such as, for example, aluminum (Al) into a layer on the glass substrate by means of a method such as a sputtering method, and patterning it into a predetermined shape by means of, for example, a photolithographic method. In this embodiment, the pixel electrodes 31a are formed into linear shapes, and two pixel electrodes 31a configure one column.

The wiring electrodes 31b are configured by forming a material such as aluminum (Al), which has a low electric resistance, into a layer on the glass substrate by means of a method such as a sputtering method, and patterning it into a predetermined shape by means of, for example, a photolithographic method. The wiring electrodes 31b, being formed wired below the pixel electrodes 31a across an insulating layer, are wired in such a way as to be connected to the individual pixel electrodes 31a. Also, as shown in the sectional view of a main portion in Fig. 10, each of the wiring electrodes 31b is connected to each pixel electrode 31a through a hole 33a formed in the insulating layer 33. In Fig. 10, 34 is the previously described insulating film for short circuit prevention, 35 a functional organic layer, and 36 is the glass substrate. Also, the wiring electrodes 31b are each connected to a signal electrode side drive circuit 37. The signal electrode side drive circuit 37 is one which supplies electric power to each pixel electrode 31a via the wiring electrodes 31b in order to display a predetermined image in accordance with a sequential scanning of the scanning electrodes 32 by a scanning electrode side drive circuit 38, to be described hereafter.

The scanning electrodes 32 are configured by, as well as forming a conductive material such as aluminum (Al) into a layer by means of a vapor deposition method or the like, separating and forming it into a plurality of rows of linear shapes by means of ribs 32a configured by forming an insulating resin material into linear shapes. The scanning electrodes 32 are formed in such a way that a plurality thereof intersect one pixel electrode 31a. Also, the scanning electrodes 32, of which those intersecting the same pixel electrode 31a are classified as one unit, are each connected to the scanning electrode side drive circuit 38. The scanning electrode side drive circuit 38 is one which scans a plurality of scanning electrodes 32 classified as differing units using a predetermined duty ratio, in order, with the same timing.

Such an organic EL display is configured so that two pixel electrodes 31a connected to each differing wiring electrode 31b are disposed in such a way as to face two units of scanning electrodes 32 to be duty driven with the same timing. That is, it is possible to, when scanning two lines of scanning electrodes 32 at the same time, individually controlling the lighting of two dots in a vertical direction (a direction perpendicular to the scanning electrodes 32) of a display section by means of the signal electrode side drive circuit 37 side, and even in the event of increasing the number of dots in the vertical direction, it is possible to suppress a decrease in luminance lifetime, an increase in voltage, or an increase in consumption current and consumption power. Furthermore, with the organic EL display of this embodiment, it being possible to reduce a dimension between dots by wiring the wiring electrodes 31b below the pixel electrodes 31a across the insulating layer 33, it is possible to realize an increase in definition of the display section in spite of an increase of the wiring electrodes 31b.

In this embodiment, a configuration is one compatible with the dual scan method which drives and controls two lines of scanning electrodes 32 with the same timing but, in the invention, it is also acceptable to adopt one compatible with a configuration (a triple scan method) which drives and controls three or more lines of scanning electrodes with the same timing. With such a configuration, by disposing the wiring electrodes below the pixel electrodes across the insulating layer, it is possible to realize the increase in definition of the display section in spite of the increase of the wiring electrodes.

### Industrial Applicability

The invention relates to the organic EL display using the organic electroluminescence (EL) element, and particularly, is suitable for a passive drive organic EL display.

## Claims

1. An organic EL display comprising an organic EL element in which a functional organic layer having at least a light emitting layer between signal electrodes and scanning electrodes, which are disposed facing each other so as to intersect each other, is formed laminated on a substrate,
wherein the signal electrodes have a plurality of pixel electrodes disposed in a matrix form and each of the plurality of wiring electrodes are connected to each of the corresponding pixel electrodes in each column of pixel electrodes,
at least some of the wiring electrodes are formed stacked one above the other across an insulating layer, and
each of a plurality of the scanning electrodes are formed so as to face the plurality of pixel electrodes connected to each corresponding wiring electrode in each column of pixel electrodes.

2. The organic EL display according to claim 1,
wherein scanning electrodes facing pixel electrodes connected to the same wiring electrode are classified as one unit, and
a plurality of the scanning electrodes classified as differing units are driven and controlled with the same timing.

3. An organic EL display including an organic EL element in which a functional organic layer having at least a light emitting layer between signal electrodes and scanning electrodes, which are disposed facing each other in such a way as to intersect each other, is formed laminated on a substrate,
wherein the signal electrodes have a plurality of pixel electrodes disposed in a matrix and each of the plurality of wiring electrodes are connected to each corresponding pixel electrode in each column of pixel electrodes,
at least some of the wiring electrodes are formed stacked one above the other across an insulating layer,
a plurality of the scanning electrodes are formed so as to intersect the pixel electrode in each column of pixel electrodes, and scanning electrodes intersecting the same pixel electrode are classified as one unit, and
a plurality of the scanning electrodes classified as differing units are driven and controlled with the same timing.

4. The organic EL display according to claim 1 or 3, wherein the wiring electrodes are wired between adjacent columns of pixel electrodes.

5. The organic EL display according to claim 1 or 3, wherein the wiring electrodes are made of a material with a lower electric resistance than that of the pixel electrodes.

6. The organic EL display according to claim 1 or 3, wherein the wiring electrodes are wired toward one edge of the substrate.

7. An organic EL display including an organic EL element in which a functional organic layer having at least a light emitting layer between signal electrodes and scanning electrodes, which are disposed facing each other so as to intersect each other, is formed laminated on a substrate,
wherein the signal electrodes have a plurality of pixel electrodes disposed in a matrix form, and each of the plurality of wiring electrodes are connected to each of corresponding pixel electrodes in each column of pixel electrodes, and formed below the pixel electrodes across an insulating layer, and
each of a plurality of the scanning electrodes are formed so as to face the plurality of pixel electrodes connected to each corresponding wiring electrode in each column of pixel electrodes.

8. An organic EL display including an organic EL element in which a functional organic layer having at least a light emitting layer between signal electrodes and scanning electrodes, which are disposed facing each other in such a way as to intersect each other, is formed laminated on a substrate,
wherein the signal electrodes have a plurality of pixel electrodes disposed in a matrix form, and each of the plurality of wiring electrodes are connected to each of corresponding pixel electrodes in each column of pixel electrodes, and formed below the pixel electrodes across an insulating layer,
a plurality of the scanning electrodes are formed so as to intersect the pixel electrode in each column of pixel electrodes, and scanning electrodes intersecting the same pixel electrode are classified as one unit, and
a plurality of the scanning electrodes classified as differing units are driven and controlled with the same timing.

9. The organic EL display according to claim 8, wherein a hole for connecting the pixel electrodes and wiring electrodes is formed in the insulating layer.

10. The organic EL display according to claim 7 or 8, wherein the wiring electrodes are wired toward one edge of the substrate.
